# FASCICULE DE BREVET EUROPEEN

(11) **EP 4 433 772 B1**
(45) Date de publication et mention de la délivrance du brevet: **21.10.2026**
(21) Numéro de dépôt: 22818356.2
(22) Date de dépôt: 17.11.2022
(51) Int. Cl.: G01B 11/24, G01M 11/02, G01B 9/02, G01B 9/0209

(54) **PROCÉDÉ DE CARACTÉRISATION GÉOMÉTRIQUE D'OBJECTIFS OPTIQUES**
VERFAHREN ZUR GEOMETRISCHEN CHARAKTERISIERUNG VON OPTISCHEN LINSEN
METHOD FOR THE GEOMETRIC CHARACTERISATION OF OPTICAL LENSES

(30) Priorité: 19.11.2021 FR 2112263
(43) Date de publication de la demande: 25.09.2024
(73) Titulaire: Fogale Nanotech, 30900 Nîmes (FR)
(72) Inventeur: LEGROS, Mr Eric, 30900 NÎMES (FR); PETITGRAND, Sylvain, 30132 CAISSARGUES (FR); PORQUE, Jérôme, 34280 LA GRANDE MOTTE (FR)
(74) Mandataire: IPAZ
(86) Numéro de dépôt international: PCT/EP2022/082252
(87) Numéro de publication internationale: WO 2023/089017

(56) Documents cités:
- EP-A1- 3 676 677
- WO-A1-2020/245511
- CN-A- 112 484 968
- US-A1- 2021 088 327

## Description

La présente invention concerne un procédé de caractérisation géométrique d'un objectif optique, en particulier avant sa fabrication ou pendant sa fabrication, en vue d'estimer au moins un indicateur relatif à la qualité de l'objectif optique une fois assemblé. Elle concerne également un dispositif de caractérisation géométrique mettant en œuvre un tel procédé. Elle concerne en outre un procédé et un système de fabrication d'objectifs optiques mettant en œuvre un tel procédé, ou dispositif, de caractérisation géométrique.

Le domaine de l'invention est le domaine de la caractérisation qualitative des objectifs optiques, en particulier avant ou pendant leur fabrication.

### État de la technique

Un objectif optique est constitué par un empilement d'éléments optiques, dans un barillet, dans un ordre donné et suivant une direction d'empilement, également appelé l'axe Z. Les éléments optiques d'un objectif optique, également appelé objectif dans la suite, peuvent être des lentilles optiques convergentes, divergentes, asphériques, ou éventuellement d'autres formes complexes, ou une entretoise, également appelé « spacer » ou en anglais ou « SOMA ^{®} », ou encore des lames ou des filtres.

Les objectifs optiques sont utilisés dans divers appareils, tels que par exemple des caméras, des appareils photos, des Smartphones, etc. pour imager une scène, ou alors en tant que source lumineuse, pour projeter des motifs, éclairer une scène, etc.

Une fois assemblé, l'objectif optique est testé pour déterminer une donnée de performance relative au fonctionnement dudit objectif, principalement pour valider ou non la qualité dudit objectif. Il existe actuellement différentes techniques pour tester un objectif optique après sa fabrication, tel que par exemple la mesure de valeur de MTF (pour « Modulation Transfer Function » en anglais, ou « Fonction de Transfert de Modulation » en français). D'autres exemples de caractérisation d'objectifs optiques ou d'éléments d'objectifs optiques sont décrits par les documents US2021/088327 ou WO2020/245511.

Une des limitations des techniques actuelles de caractérisation est qu'elles nécessitent de terminer la fabrication de l'objectif optique avant de pouvoir caractériser l'objectif optique. Ainsi, lorsque l'objectif optique est jugé insatisfaisant, il est souvent mis au rebut, ce qui constitue une perte de temps et de ressources.

Par conséquent, les techniques actuelles ne permettent pas d'améliorer l'efficacité de production d'objectifs optiques puisque ces techniques interviennent à un stade très tardif de la fabrication de l'objectif optique.

Un but de la présente invention est de remédier à au moins un des inconvénients précités.

Un autre but de l'invention est de proposer une solution de caractérisation d'objectifs optiques moins chronophage et plus efficace.

Un autre but de l'invention est de proposer une solution de caractérisation d'objectifs optiques permettant d'améliorer la mise au point des procédés de fabrication des objectifs optiques et de leurs composants.

Un autre but de l'invention est de proposer une solution de caractérisation d'objectifs optiques permettant d'améliorer l'efficacité de production des objectifs optiques.

### Exposé de l'invention

Suivant la revendication 1, l'invention propose d'atteindre au moins l'un des buts précités par un procédé mis en oeuvre par ordinateur de caractérisation géométrique d'un objectif optique cible à fabriquer par empilement de plusieurs éléments optiques, ledit procédé comprenant une phase de caractérisation comprenant les étapes suivantes :
- détermination, d'un jeu, dit jeu d'assemblage, comprenant, pour chacun d'au moins deux éléments optiques, un jeu, dit jeu individuel, comprenant au moins un paramètre caractéristique dudit élément optique ; et
- fourniture, en fonction dudit jeu d'assemblage, d'un jeu de données, dit jeu géométrique estimé, comprenant des données relatives à au moins un paramètre géométrique pour chacune d'au moins deux interfaces optiques dudit empilement, par un modèle de caractérisation géométrique préalablement entrainé avec une base, dite base d'entrainement, de jeux d'entrainements constituée à partir d'objectifs optiques d'architecture identique à celle dudit objectif cible.

Ainsi, le procédé selon l'invention permet de fournir, par estimation, au moins un paramètre géométrique relatif à au moins une, et en particulier chaque, interface optique de l'objectif optique cible qui sera obtenu en fonction d'au moins un paramètre caractéristique d'au moins un, en particulier de chaque, élément optique composant ledit objectif optique cible. Autrement dit, avec le procédé selon l'invention, il est possible d'obtenir un indicateur estimé concernant l'objectif optique avant sa fabrication. Cet indicateur estimé, fourni par le procédé selon l'invention, peut être utilisé pour estimer la qualité, ou la performance fonctionnelle, de l'objectif cible une fois fabriqué, par exemple par comparaison à un seuil, ou une fourchette de valeurs, pour déterminer si l'objectif optique cible, une fois fabriqué, serait performant ou non. Ainsi, il est possible d'avoir un avis sur la performance de l'objectif cible avant même de commencer sa fabrication, ou pendant sa fabrication. Le procédé selon l'invention permet, par conséquent, d'augmenter l'efficacité de fabrication d'objectifs optiques, cette efficacité étant définie comme étant le nombre d'objectifs optiques satisfaisants divisé par le nombre total d'objectifs optiques fabriqués. Le procédé selon l'invention permet aussi de diminuer les pertes de temps et de coût liés à la production d'un objectif optique dont les performances ne seraient pas satisfaisantes.

De plus, la caractérisation d'un objectif optique à partir des paramètres des éléments optiques qui le composent est plus rapide et moins chronophage, comparée aux techniques actuelles de caractérisation, telles que des techniques de caractérisation par mesure de valeurs de MTF.

Surtout, l'invention permet de donner une indication sur la qualité de l'objectif optique en partant des éléments optiques qui le composent. Ainsi, il est possible d'ajuster la composition de l'objectif optique, par exemple en remplaçant un élément optique par un autre ou modifiant l'agencement d'un optique, au moment même de la conception de l'objectif optique. En effet, les caractéristiques de chaque composant optique de l'objectif peuvent être connues avant commencer la fabrication de l'objectif optique, voire même au moment de la conception de l'objectif optique, voire encore au moment de la conception de chaque élément optique. Ainsi, l'invention permet d'obtenir une indication sur la qualité de l'objectif optique très en amont du processus de fabrication,

Au moins une donnée du jeu géométrique estimé, et en particulier le jeu géométrique estimé, peut être comparé(e) au moins une valeur seuil, ou une fourchette de valeurs, prédéterminée, pour obtenir une indication sur la qualité fonctionnelle ou la performance fonctionnelle de l'objectif optique cible.

Cette indication peut être une classification de l'objectif optique cible telle que « bon » ou « pas bon ». Alternativement, ou en plus, cette indication peut être tout autre type de données.

Les éléments optiques composant un objectif optique sont empilés suivant une direction d'empilement, également appelé axe Z dans la suite, ou encore l'axe de l'objectif optique. Le plan perpendiculaire à l'axe Z, c'est-à-dire le plan selon lequel chaque élément optique s'étend, est appelé le plan X-Y dans la suite.

Dans la présente demande, le modèle de caractérisation géométrique, également appelé modèle de caractérisation dans la suite, fournit des données relatives à la géométrie des interfaces optiques de l'objectif, également appelé « paramètre géométrique » de l'interface optique, dans la présente demande.

Par « paramètre géométrique d'une interface optique », on entend, par exemple, et sans perte de généralité :
- une position de l'interface optique au sein de l'objectif, dans l'axe Z ;
- une position d'un APEX de l'interface optique, en particulier dans le plan X-Y et/ou
- une position d'un APEX de l'interface optique, en particulier selon l'axe Z,
- une inclinaison (TIP et/ou TILT) de ladite interface optique par rapport à l'axe Z,
- un décentrement d'une interface optique, ou d'un élément optique, par rapport à l'axe Z, dans le plan X-Y.

Deux objectifs optiques ont une architecture identique lorsque chacun de ces objectifs optiques comprennent par conception des éléments optiques identiques empilés par conception de manière identique.

Dans la présente demande, par « interface optique enterrée » d'un objectif optique, on entend une interface au sein de l'objectif optique qui n'est visible, ou accessible, que par l'intermédiaire d'au moins une autre interface optique de l'objectif. L'au moins une autre interface optique au travers de laquelle l'interface enterrée est visible peut être une interface optique d'un même élément optique, ou une interface optique d'un autre élément optique que l'interface enterrée.

Le jeu géométrique estimé peut comprendre des données relatives à au moins un paramètre géométrique d'au moins une interface enterrée dudit empilement.

Le jeu géométrique estimé peut comprendre des données relatives à au moins un paramètre géométrique d'au moins une interface non enterrée dudit empilement.

Suivant des modes de réalisation, au moins un jeu individuel, noté JI dans la suite, d'un élément optique peut comprendre une combinaison quelconque d'au moins un des paramètres suivants :
- au moins un paramètre optique dudit élément optique ;
- au moins un paramètre géométrique dudit élément optique ;
- au moins un paramètre de fabrication dudit élément optique.

Par exemple, au moins un paramètre optique d'un élément optique peut être un des paramètres optiques suivants :
- un indice de réfraction,
- un nombre d'Abbé,
- etc.

Par exemple, au moins un paramètre géométrique d'un élément optique peut être un des paramètres géométriques suivants :
- une forme géométrique d'une, en particulier de chaque, interface optique de l'élément optique,
- un centre de courbure d'une, en particulier de chaque, interface optique de l'élément optique,
- une position d'un apex d'une, en particulier de chaque, interface optique de l'élément optique,
- au moins une épaisseur dudit élément optique le long de la circonférence dudit élément optique,
- un diamètre intérieur, et/ou un diamètre extérieur, dudit élément optique
- une concentricité, ou une excentricité, des interfaces optiques de l'élément optique,
- une rugosité de surface d'au moins une, en particulier de chaque, interface de l'élément optique,
- etc.

Par exemple, au moins un paramètre fabrication d'un élément optique peut être au moins un des paramètres de fabrication suivants :
- une température de moulage,
- une pression de moulage,
- un temps de moulage,
- un polymère utilisé pour le moulage,
- etc.

Au moins un paramètre d'un élément optique peut être fourni par un fournisseur, ou un fabricant.

Un tel paramètre peut faire partie des spécifications de l'élément optique au moment de sa conception, ou mesuré pendant, ou après, la fabrication de l'élément optique.

Un tel paramètre peut être l'un quelconque des paramètres listés plus haut.

Alternativement, ou en plus, au moins un paramètre d'un élément optique peut être calculé à partir d'une modélisation numérique dudit élément.

En effet, il existe différents outils logiciels de simulation et de conception, tels que par exemple, « OSLO ^{®} » ^{®} ou « Zemax ^{®} », permettant de modéliser numériquement un élément optique pour déterminer au moins une caractéristique dudit élément optique, par simulation, à partir de sa modélisation numérique.

Un tel paramètre peut être l'un quelconque des paramètres listés plus haut.

Alternativement, ou en plus, au moins un paramètre d'un élément optique peut être mesuré par un dispositif de mesure.

Par exemple, au moins un paramètre géométrique peut être obtenu par un appareil de profilométrie optique ou un appareil de profilométrie mécanique. En effet, un tel appareil permet de détecter la forme de l'élément optique, l'épaisseur de l'élément optique, la position des APEX, la rugosité, etc.

Par exemple, au moins un paramètre géométrique peut être obtenu par un appareil d'interférométrie optique en mode point ou en mode plein champ.

Un tel paramètre peut être l'un quelconque des paramètres listés plus haut.

Suivant des modes de réalisation, le jeu géométrique estimé peut comprendre des données estimées d'une partie, ou de la totalité, de valeurs brutes de mesure(s) optique(s) obtenues à partir de l'empilement d'éléments optiques dudit objectif optique cible

Par exemple, le jeu géométrique peut comprendre des données estimées de mesure(s) confocale(s), ou des données estimées de mesure(s) d'interférométrie optique, exécutées sur l'empilement d'élément optique. Autrement dit, le jeu géométrique estimé peut comprendre des données estimées de mesures optiques, sans réaliser ces mesures optiques. Ainsi le procédé selon l'invention permet de faciliter et d'accélérer les phases de développement des procédés de fabrication des objectifs optiques dans un premier temps et d'améliorer le suivi et la mise en œuvre de la production dans un second temps.

Le jeu géométrique peut en particulier comprendre des données estimées de mesures optiques réalisées uniquement depuis une face, ou un côté, de l'empilement d'éléments optiques, sans avoir à retourner ledit empilement. Ainsi, le jeu géométrique estimé comprend des données estimées relatives à au moins une, et en particulier à chaque, interface optique de l'objectif optique, y compris chaque interface optique enterrée, de l'empilement d'éléments optiques.

Selon des modes de réalisation, le jeu géométrique estimé peut comprendre des données estimées d'au moins une mesure confocale réalisée sur l'empilement d'éléments optiques de l'objectif optique cible, préférentiellement depuis une face de dudit empilement.

De manière classique, une mesure confocale est réalisée avec un appareil qui comprend une première ouverture (orifice) imagée sur la surface à mesurer par l'intermédiaire d'une lentille de focalisation. Cette ouverture est éclairée par un faisceau lumineux provenant d'une source de lumière et qui est ensuite dirigé vers la surface à mesurer. Lorsque le faisceau est réfléchi par une surface, il est redirigé vers la lentille de focalisation puis vers une seconde lentille placée devant un élément de détection et de façon à être l'image conjuguée du point illuminé sur la surface mesurée. L'avantage d'une telle configuration est la réduction de la profondeur de champ et donc de pouvoir distinguer plus facilement des objets (ou surfaces) les unes sous les autres. Pour réaliser la détection, le système de mesure confocale est déplacé relativement par rapport à l'objet mesuré. Un maximum d'intensité est détecté sur l'élément de détection lorsqu'une surface entre dans le point de focalisation définie par la lentille de focalisation. Une configuration particulière d'un système de mesure confocale utilise une lentille chromatique pour focaliser et imager un faisceau issu d'une source polychromatique. Les différentes longueurs d'ondes définissent ainsi différents points de focalisation le long de l'axe optique de la lentille. La détection avec un spectromètre de la lumière réfléchie permet de reconnaître la longueur d'onde réfléchie et en déduire une information de hauteur (ou distance) entre la lentille et la surface mesurée. Une telle configuration permet d'éliminer ou de réduire le déplacement du système de mesure confocale. Notamment, lorsque le système de mesure confocale est déplacé selon un plan perpendiculaire à l'axe d'illumination de la surface à mesurer, des informations de topographie d'une surface peuvent être obtenues.

Selon des modes de réalisation, le jeu géométrique estimé peut comprendre des données estimées d'au moins une mesure d'interférométrie optique réalisée sur l'empilement d'éléments optiques de l'objectif optique cible, préférentiellement depuis une face dudit empilement.

De manière classique, une mesure d'interférométrie optique est réalisée avec un appareil d'interférométrie optique comprenant une source de lumière à faible cohérence émettant. Cette source de lumière émet, en direction de l'empilement d'éléments optiques, et plus particulièrement selon l'axe Z, un faisceau de lumière, appelé faisceau de mesure. Le faisceau de mesure, illumine l'empilement d'éléments optiques en un point de mesure plus ou moins large selon la focalisation dans le plan X-Y, et parcourt alors l'empilement d'éléments optiques, en particulier dans la direction d'empilement, et traverse chaque interface optique à tour de rôle. À chaque interface optique, une partie du faisceau est réfléchie, et constitue un faisceau réfléchi. Ce faisceau réfléchi est alors capté par un capteur se trouvant du même côté que la source d'émission, et est caractérisé par interférométrie optique avec un faisceau de référence provenant aussi de la source de lumière. Par « zone de cohérence », on entend la zone dans laquelle des interférences entre le faisceau de mesure et le faisceau de référence peuvent se former sur le capteur. La zone de cohérence peut être déplacée en variant la différence de la longueur du chemin optique entre les deux faisceaux, par exemple en modifiant la longueur optique d'un des faisceaux ou des deux. L'appareil d'interférométrie optique permet de détecter sélectivement un signal d'interférence pour chaque interface au niveau de laquelle la zone de cohérence est positionnée, c'est-à-dire pour chaque surface se trouvant dans la zone de cohérence. Préférentiellement, la longueur de cohérence de la source lumineuse est ajustée de sorte à être plus courte qu'une distance optique minimale entre deux interfaces adjacentes de l'élément optique. Ainsi, pour chaque mesure, une seule interface se trouve dans la zone de cohérence, et donc, un signal d'interférence acquis ne comprend que la contribution d'une seule interface, ou ne provient que d'une seule interface. Les mesures des interférences sont effectuées selon un champ de vue déterminé par les moyens de mesure de l'appareil d'interférométrique.

Selon un mode de réalisation, l'appareil interférométrique peut opérer en mode point en étant configuré pour détecter un signal d'interférence ponctuel en un point du champ de vue ou en un détecteur ponctuel. Le jeu géométrique estimé peut être, ou peut comprendre, le signal d'interférence ou l'interférogramme qui est un signal d'intensité fonction du déplacement de la zone de cohérence le long de l'axe z. Le signal d'interférence peut, par exemple, être vu comme une succession de raies d'interférence associées à chaque interface optique.

Alternativement ou en plus, l'appareil interférométrique peut comprendre un capteur interférométrique, dit capteur interférométrique en plein champ, configuré pour détecter un signal d'interférence en plein champ dans un champ de vue et représenté, par exemple, sous la forme d'une image 2D (image d'interférence) grâce à l'élément de détection.

Une interface à mesurer peut ainsi être imagée selon le champ de vue en une seule mesure ou par balayage d'un faisceau.

Dans un exemple particulier de mise en œuvre, un signal de mesure peut être formé par un signal d'interférence ponctuel associé à un pixel de l'élément de détection dont l'intensité est détectée suivant le déplacement en Z de la zone de cohérence.

Selon un exemple, l'appareil interférométrique peut comprendre un capteur interférométrique avec un interféromètre de Michelson. Selon un autre exemple, l'appareil interférométrique peut comprendre un capteur interférométrique avec un interféromètre de Mach-Zehnder.

Selon des modes de réalisation, un appareil interférométrique en mode point et un appareil interférométrique en plein champ peuvent être associés.

Suivant des modes de réalisation, le jeu géométrique estimé peut comprendre des données estimées d'une partie ou de la totalité de valeurs brutes d'interférométrie optique obtenues à partir de l'empilement d'éléments optiques dudit objectif optique cible.

Autrement dit, dans ce cas, le modèle de caractérisation géométrique prend en entrée un jeu d'assemblage et fournit en sortie un jeu géométrique estimé comprenant des données de mesures brutes estimées d'interférométrie optique.

Les données brutes estimées d'interférométrie optique peuvent comprendre, pour chaque interface optique :
- **en mode point** : au moins une raie d'interférence dont la position et l'amplitude dépendent de la distance géométrique à laquelle se trouve ladite interface optique, par rapport à un point/plan de référence, au point de mesure. En particulier, le point/plan de référence est le point/plan d'émission de l'onde de mesure, ou alors d'une interface de référence connue faisant partie du dispositif de mesure. Ainsi, la position d'une raie d'interférence permet de déterminer la distance à laquelle se trouve l'interface optique qui lui est associée, au point de mesure.
- **en mode plein champ** : une séquence de signaux d'interférence 2D acquis pour une pluralité de différences de trajets optiques permettant d'obtenir des informations de forme des interfaces optiques. Ces séquences peuvent être acquises de différentes manières selon la technique d'analyse mise en œuvre. La pluralité de signaux d'interférence 2D peut notamment être acquise selon une méthode interférométrique par décalage de phase ou selon une méthode interférométrique par balayage vertical. Selon un autre mode de réalisation nullement limitatif, le signal d'interférence peut être traité par un procédé de calcul par holographie numérique. Typiquement, les signaux d'interférence 2D comportent une information d'amplitude et une information de phase. Des images associées à ces informations d'amplitude et des images associées à ces informations de phase peuvent être construites à partir des signaux d'interférence.

Par exemple, le jeu géométrique estimé peut comprendre une estimation du signal d'interférence mesuré.

Par exemple, le jeu géométrique estimé peut comprendre des données brutes estimées représentant, pour au moins une raie d'interférence, la position, et éventuellement l'amplitude de ladite raie d'interférence.

Selon un autre exemple, le jeu géométrique estimé peut comprendre des données brutes estimées représentant l'image d'amplitude et/ou l'image de phase associées à une image d'interférence.

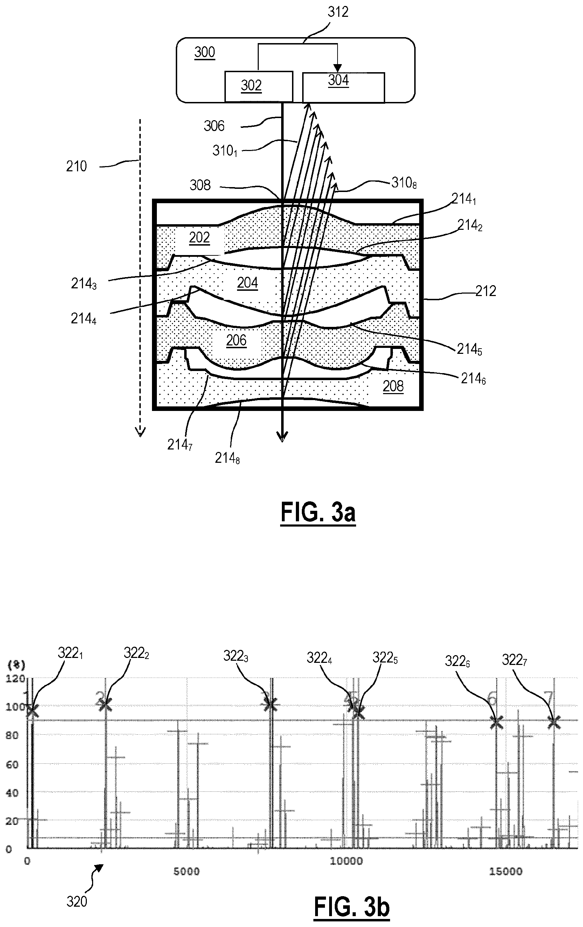

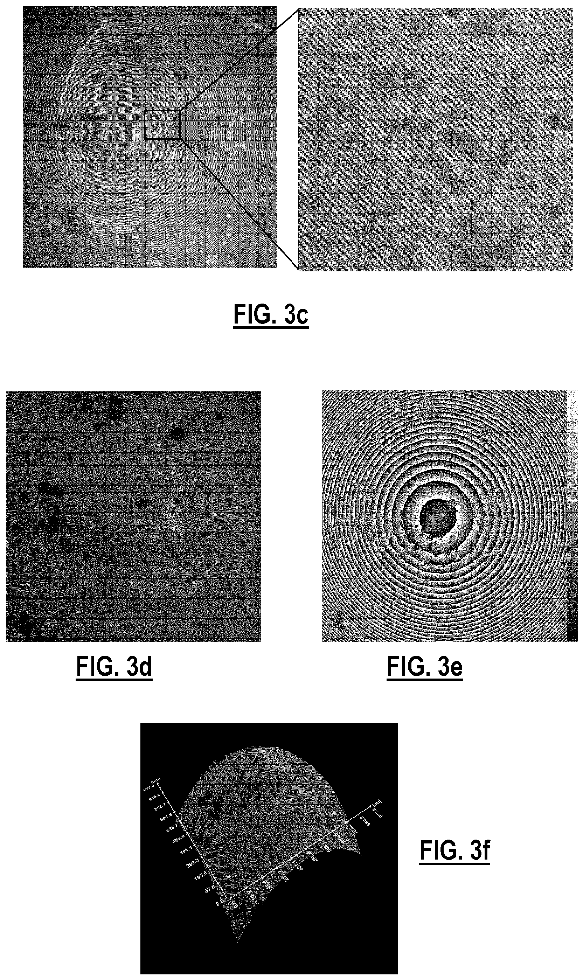

Un exemple de données brutes est donné plus loin en référence à la FIGURE 3b pour un exemple d'interférométrie en mode point et à en référence aux FIGURES 3c-3f pour un exemple d'interférométrie en mode plein champ.

Suivant des modes de réalisation, le jeu géométrique estimé peut comprendre une valeur estimée d'au moins un paramètre géométrique d'une interface optique de l'objectif cible.

Par exemple, le jeu géométrique estimé peut comprendre, pour au moins une interface optique, ou un élément optique, de l'empilement :
- au moins une valeur estimée de position d'une interface, ou d'un élément, optique de l'objectif ;
- au moins une valeur estimée d'épaisseur d'un élément optique de l'objectif ;
- au moins une valeur estimée de décentrement d'au moins une interface, ou d'un élément, optique par rapport à l'axe Z, ou relativement à une position de centre d'une autre interface, dans le plan X-Y ; ou
- au moins une valeur estimée d'inclinaison d'au moins une interface, ou d'un élément, optique par rapport à l'axe Z, ou relativement à l'inclinaison une autre interface.
- au moins une valeur estimée de topographie ou de profil de forme d'au moins une interface, par exemple par rapport à un plan ou un axe de référence pour en déduire, par exemple, des valeurs de décentrement ou d'inclinaison.

La position selon l'axe Z d'une interface optique peut être déterminée comme étant la position d'une raie d'interférence correspondant à ladite interface.

L'épaisseur d'un élément optique, selon l'axe Z, peut être déterminée en calculant la distance entre les raies d'interférence correspondant à chacune des interfaces optiques dudit élément optique.

La position d'une interface optique par rapport à l'axe Z peut être déterminée en effectuant plusieurs mesures d'interférométrie optique, en particulier dans une zone centrale de l'objectif optique. En suivant, sur les plusieurs mesures, la position, selon l'axe Z, de la raie d'interférence associée à ladite interface, il est possible de déterminer la position de l'APEX de ladite interface optique. La position de l'APEX de l'interface optique permet de déterminer la position de ladite interface par rapport à l'axe Z, dans le plan X-Y, et donc son décentrement par rapport à l'axe Z.

Dans un autre exemple, la position d'une interface par rapport à l'axe Z peut être obtenue, par exemple, par détection d'une image d'interférence de l'interface dans une zone centrale de l'objectif optique et analyse de cette image et/ou analyse des images d'amplitudes ou de phases associées, notamment pour obtenir un profil de cette surface et la position de l'APEX de ladite interface optique.

La position d'un élément optique par rapport à l'axe Z peut être déterminée en fonction des positions de ces interfaces optiques.

L'inclinaison d'une interface optique par rapport à l'axe Z peut être déterminée en effectuant plusieurs mesures d'interférométrie optique, en particulier dans une zone périphérique de l'objectif optique. En suivant, sur les plusieurs mesures, la position dans l'axe Z, de la raie d'interférence associée à ladite interface, il est possible de déterminer la position de l'interface selon l'axe au niveau de ses bords, ce qui permet de déterminer l'inclinaison de ladite interface par rapport à l'axe Z.

L'inclinaison d'un élément optique par rapport à l'axe Z peut être déterminée en fonction des inclinaisons de ses interfaces optiques.

Il est également possible de déterminer chacun de ces paramètres géométriques en utilisant l'amplitude d'une raie d'interférence, en plus ou à la place de la position de la raie d'interférence.

Suivant des modes de réalisation, au moins un jeu d'entrainement peut comprendre :
- au moins un jeu d'assemblage, dit d'entrainement, obtenu à partir d'un objectif optique, dite d'entrainement, d'architecture identique à l'architecture de l'objectif cible, et
- au moins un jeu géométrique, dit d'entrainement, obtenu à partir dudit objectif optique d'entrainement.

Bien entendu, chaque jeu d'assemblage d'entrainement, respectivement chaque jeu géométrique d'entrainement, comprend des données de même nature présentées suivant un même formalisme que le jeu d'assemblage, respectivement le jeu géométrique estimé. Par conséquent, toutes les caractéristiques décrites plus haut en référence au jeu d'assemblage, respectivement au jeu géométrique estimé, s'applique au jeu d'assemblage d'entrainement, respectivement au jeu géométrique d'entrainement.

Suivant des modes de réalisation, pour au moins un jeu d'entrainement, le jeu d'assemblage d'entrainement peut être obtenu, en partie ou en totalité, par simulation.

Par exemple, durant la phase de conception d'un élément optique faisant partie de l'empilement de l'objectif optique, son architecture peut être modélisée en représentant les interfaces optiques (particulièrement celles des lentilles) par des formulations analytiques et en indiquant numériquement leurs espacements. Les valeurs théoriques d'indice de réfraction et de nombre d'Abbé des matériaux impliqués peuvent aussi être données. Ces valeurs théoriques peuvent ensuite être entrées dans des logiciels de conception optique, disponibles commercialement, tels que cités plus haut, par exemple, pour simuler des paramètres caractéristiques définissant ledit élément optique.

Suivant des modes de réalisation, pour au moins un jeu d'entrainement, le jeu d'assemblage d'entrainement peut être obtenu, en partie ou en totalité, par mesure.

Dans ce cas, au moins un paramètre dudit jeu d'assemblage d'entrainement est mesuré, par exemple de manière similaire à ce qui est décrit plus haut en référence au jeu d'assemblage.

Suivant des modes de réalisation particulièrement avantageux, au moins un jeu d'entrainement peut être obtenu à partir d'un objectif d'entrainement faisant partie d'un même lot d'objectifs que l'objectif cible, lors de la fabrication dudit lot d'objectifs.

Autrement dit, dans ce cas, la base d'entrainement est obtenue, en partie ou en totalité, à partir d'objectifs optiques faisant partie du même lot que l'objectif optique cible et qui ont été fabriqués préalablement. Ainsi, le modèle de caractérisation est plus précis et permet de réaliser une caractérisation géométrique plus précise.

Par « objectifs de même lot », on entend des objectifs qui proviennent d'une même architecture (même « design ») conçue pour que les objectifs réalisent une performance optique similaire. En supplément, ces objectifs peuvent aussi avoir des caractéristiques de fabrication communes telles que provenir d'une même ligne de production, être produits avec une machine commune, à des périodes semblables, etc...

Dans ce cas, une première partie des objectifs optique fabriqués d'un même lot est utilisée pour constituer une base d'entrainement. En particulier, pour chaque objectif optique de cette première partie du lot, il est constitué un jeu d'entrainement comprenant :
- un jeu d'assemblage d'entrainement : ce dernier comprenant au moins un paramètre d'au moins un élément optique qui est soit mesuré, soit renseigné par un fournisseur, ou encore obtenu par simulation ;et
- au moins un jeu géométrique d'entrainement : ce dernier comprenant au moins une donnée relative à au moins un paramètre géométrique d'au moins une, en particulier de chaque, interface optique de l'empilement, qui est soit mesurée, par exemple par une mesure confocale ou par une mesure d'interférométrie, soit obtenue par simulation à partir d'une modélisation numérique de l'objectif optique concerné.

Ainsi, les premiers objectifs optiques fabriqués d'un lot permettent de constituer une base d'entrainement. Cette dernière est utilisée pour entrainer le modèle de caractérisation géométrique. Une fois le modèle de caractérisation géométrique entrainé, il est utilisé pour caractériser les objectifs optiques suivants dudit lot.

Suivant des modes de réalisation, pour au moins un jeu d'entrainement, le jeu géométrique d'entrainement peut être obtenu, en partie ou en totalité, par mesure.

Dans ce cas, ledit jeu géométrique d'entrainement peut être mesuré par au moins une mesure confocale, et/ou au moins une mesure interférométrique, tel que décrit plus haut, pour fournir soit des données brutes relatives à, soit des valeurs de, au moins un paramètre géométrique d'au moins une interface optique de l'empilement optique.

Suivant des modes de réalisation, pour au moins un jeu d'entrainement, le jeu géométrique d'entrainement peut être obtenu, en partie ou en totalité, par simulation.

Par exemple, durant la phase de conception d'un objectif optique, son architecture peut être modélisée en représentant les interfaces optiques (particulièrement celles des lentilles) par des formulations analytiques et en indiquant numériquement leurs espacements. Les valeurs théoriques d'indice de réfraction et de nombre d'Abbé des matériaux impliqués peuvent aussi être données. Ces valeurs théoriques peuvent ensuite être entrées dans des logiciels de conception optique, disponibles commercialement, pour simuler et optimiser les paramètres définissant l'objectif en calculant les performances fonctionnelles théoriques. Il est ainsi possible de calculer assez parfaitement les propriétés de transfert optique par simulation de la propagation de rayons optiques, cela pour différents points de la scène à observer, et les différents points associés sur la zone de détection.

Ainsi, le jeu géométrique d'entrainement peut être obtenu par simulation. Ainsi, la base d'entrainement peut être constituée, en partie ou en totalité, par simulation ce qui est plus rapide, et implique moins d'effort et de ressources.

Suivant des modes de réalisation, le modèle de caractérisation géométrique peut comprendre :
- un réseau de neurones, en particulier régressif, et encore plus particulièrement un réseau de neurones CNN (pour « Convolutional Neural Network » en anglais ou « Réseau de Neurones à Convolution » en français) à apprentissage profond. Un tel réseau de neurones peut, de manière nullement limitative, comprendre au moins une dizaine de couches, par exemple une vingtaine de couches ;
- un modèle de régression linéaire de polynômes ;
- une équation gaussienne, obtenue par une méthode des moindres carrés ; ou
- une méthode d'analyse statistique.

Suivant des modes de réalisation, le procédé selon l'invention peut comprendre une phase d'entrainement du modèle de caractérisation géométrique avec la base d'entrainements.

La phase d'entrainement peut être réalisée avec une base d'entrainement comprenant une multitude de jeux d'entrainement, notés JE₁-JEₖ, Chaque jeu d'entrainement JEᵢ comprend :
- au moins un jeu d'assemblage d'entrainement, JAAᵢ, obtenu, par mesure ou par simulation, à partir d'un objectif optique d'entrainement dont l'architecture est identique à celle de l'objectif optique cible qui sera caractérisé par le modèle de caractérisation géométrique, une fois entrainé ;
- au moins un jeu géométrique d'entrainement, JGAᵢ, obtenu, par mesure ou par simulation, à partir dudit objectif optique d'entrainement dont l'architecture est identique à celle de l'objectif optique cible qui sera caractérisé par le modèle de caractérisation géométrique, une fois entrainé.

Lorsque le modèle de caractérisation est un réseau de neurones, en particulier un CNN, la phase d'entrainement peut comprendre une étape d'entrainement qui est réitérée plusieurs fois.

L'étape d'entrainement peut comprendre une étape de test. Cette étape de test comprend une étape lors de laquelle un jeu d'assemblage d'entrainement, par exemple JAA₁, d'un jeu d'entrainement, par exemple JE₁, est donné en entrée du réseau de neurones. Le réseau de neurones donne en sortie un jeu géométrique d'entrainement estimé, noté JGA₁^{e}.

Lors d'une étape suivante de l'étape de test, une erreur, E₁, peut être calculée entre le jeu JGAᵢ^{e} et le jeu de géométrique d'entrainement, JGA₁, dudit jeu d'entrainement JE₁. L'erreur calculée E₁ peut par exemple être une distance euclidienne ou une distance cosinus entre le jeu JGA₁^{e} et le jeu JGA₁.

L'étape de test peut être réitérée pour chaque jeu d'entrainement JE₁-JEₖ, de sorte à obtenir k valeurs d'erreur E₁-Eₖ associées respectivement à chaque jeu d'entrainement JE₁-JEₖ.

L'étape d'entrainement peut ensuite comprendre une étape de calcul d'une erreur globale, notée EG, pour l'ensemble des jeux d'entrainement, JE₁-JEₖ, par exemple en additionnant les k erreurs JE₁-JEₖ obtenues.

L'étape d'entrainement peut ensuite comprendre une étape de rétroaction, lors de laquelle les coefficients, ou poids, du réseau de neurones CNN peuvent être mis à jour, par exemple par un algorithme de rétropropagation du gradient de l'erreur.

L'étape d'entrainement peut être répétée plusieurs fois jusqu'à ce que l'erreur globale EG ne varie plus pendant plusieurs, par exemple 5, itérations successives de l'étape d'entrainement. Lorsque c'est le cas, le réseau de neurones CNN peut être considéré suffisamment entrainé et la phase d'entrainement peut être terminée.

Alternativement, ou en plus de ce qui vient d'être décrit, il est possible d'utiliser une première partie de la base d'entrainement, par exemple JE₁-JEⱼ, pour l'entrainement du réseau de neurones et une deuxième partie de la base d'entrainement, par exemple JEⱼ₊₁-JEₖ, pour valider l'entrainement du réseau de neurones. Si les sorties du réseau de neurones obtenues sont assez proches des valeurs attendues, l'apprentissage peut être considéré comme acceptable. Sinon, plus de jeux d'entrainements peuvent être présentés, ou bien la topologie du réseau peut être modifiée (nombre de couches, nombre de neurones par couches, etc.) jusqu'à obtention d'un apprentissage satisfaisant.

Bien entendu, le modèle de caractérisation fonctionnelle n'est pas limité à un réseau de neurones.

Suivant une alternative, le modèle de caractérisation fonctionnelle peut comprendre, ou peut être, une méthode de recherche de corrélations, par exemple par méthode de régression, entre le jeu d'assemblage d'entrainement JAAᵢ et le géométrique d'entrainement JGAᵢ de chaque jeu d'entrainement JEᵢ.

Suivant un exemple de réalisation, la recherche des corrélations peut se faire via une méthode des moindres carrés. Elle peut consister à la mise en place d'une relation polynomiale supposée entre les jeux JAAᵢ et IGAᵢ, et cela pour chaque JEᵢ. Ensuite, la méthode des moindres carrés permet de trouver le meilleur jeu de coefficients des polynômes qui minimise l'erreur entre les sorties calculées par les polynômes obtenus et les JGAᵢ.

Suivant la revendication 10, il est proposé un dispositif de caractérisation géométrique d'un objectif optique cible à fabriquer par empilement de plusieurs éléments optiques, ledit dispositif comprenant :
- au moins un moyen de détermination, d'un jeu, dit jeu d'assemblage, comprenant, pour au moins un élément optique, un jeu, dit jeu individuel, comprenant au moins un paramètre caractéristique dudit élément optique ; et
- un module informatique configuré pour exécuter un modèle de caractérisation géométrique préalablement entrainé avec une base, dite base d'entrainement, de jeux d'entrainements constituée à partir d'objectifs optiques d'architecture identique à celle dudit objectif cible, pour fournir, en fonction dudit jeu d'assemblage, un jeu de données, dit jeu géométrique estimé, comprenant des données relatives à au moins un paramètre géométrique d'au moins une interface optique dudit empilement.

Le dispositif de caractérisation peut de manière optionnelle comprendre une combinaison quelconque d'au moins une des caractéristiques décrites plus haut en référence au procédé de caractérisation géométrique selon l'invention et qui ne sont pas reprises ici en détail, par soucis de concision.

Le modèle de caractérisation est intégré dans un module informatique tel qu'un processeur, une puce, un ordinateur, une tablette, un serveur, etc. dédié ou non.

Suivant un autre aspect de la présente invention, il est proposé un procédé de fabrication d'un lot d'objectifs optiques comportant une deuxième phase de fabrication comprenant au moins une itération d'une étape de fabrication d'un objectif optique dudit lot comprenant les opérations suivantes :
- détermination d'un jeu d'assemblage pour ledit objectif optique, à partir de jeux individuels pour chacun des éléments optiques dudit objectif optique, et
- caractérisation dudit objectif par le procédé de caractérisation selon l'invention.

Au moins une, et en particulier chaque, valeur du jeu géométrique estimé obtenu peut être comparée à au moins une valeur géométrique, ou à une fourchette de valeurs géométriques, pour déterminer si la qualité estimée de l'objectif optique est satisfaisante.

Si la qualité estimée de l'objectif optique est satisfaisante, alors l'objectif optique peut être fabriqué.

Si la qualité estimée de l'objectif optique n'est pas satisfaisante, alors l'objectif optique peut être soumis à au moins un autre test, ou ne pas être fabriqué.

Alternativement ou en plus, si la qualité estimée de l'objectif optique n'est pas satisfaisante, alors l'objectif optique peut être retouché pour améliorer sa qualité estimée. Par exemple, au moins un élément optique de l'objectif optique peut être repositionné (par exemple être pivoté suivant un axe de rotation), ou remplacé par un autre élément optique.

Ainsi, il est possible de valider ou non un assemblage d'éléments optiques formant un objectif avant même de réaliser ledit assemblage optique, voire avant même de commencer à fabriquer ledit objectif optique. Cela permet d'augmenter l'efficacité des développements des procédés de fabrication, grâce aux informations sur les composants optiques déduites, et de la production d'objectifs optiques mettant ces procédés en œuvre grâce aux données de prédictions obtenues bien avant la finalisation complète de l'objectif, permettant ainsi, entre autres, de diminuer les pertes à la fois des composants optiques qui peuvent être dirigés vers des assemblages favorables et des objectifs.

La variation d'au moins une donnée du jeu géométrique, ou encore la qualité estimée déduite à partir du jeu géométrique estimé, peut être suivie dans le temps. Cette variation peut être utilisée pour réaliser un suivi de la fabrication des objectifs d'un même lot. Par exemple, lorsque la variation témoigne d'une déviation, ou d'une diminution, trop importante de la qualité fonctionnelle des objectifs optiques du lot, une alarme peut être générée de sorte que le procédé de fabrication peut être réajusté.

Avantageusement, le procédé de fabrication selon l'invention peut comprendre une première phase de fabrication, préalable à la deuxième phase de fabrication, comprenant au moins une itération d'une étape de fabrication d'un objectif optique dudit lot comprenant les opérations suivantes :
- détermination d'un jeu d'assemblage pour ledit objectif optique, à partir de jeux individuels des éléments optiques dudit objectif optique, et
- empilement des éléments optiques formant ledit objectif optique,
- mesure d'un jeu géométrique sur ledit objectif optique,
- mémorisation, dans une base d'entrainement, d'un jeu d'entrainement formé par :
   ▪ ledit jeu d'assemblage, et
   ▪ ledit jeu géométrique mesuré.

Cette première phase de fabrication permet de constituer une base d'entrainement pour entrainer le modèle de caractérisation géométrique utilisé lors de la deuxième phase de fabrication.

L'objectif optique peut être un objectif optique d'un Smartphone et en particulier un objectif optique d'un module caméra d'un Smartphone.

Alternativement, l'objectif optique peut être un objectif optique d'une tablette et en particulier un objectif optique d'un module caméra d'une tablette.

Alternativement, l'objectif optique peut être un objectif optique d'une caméra, et en particulier d'une caméra installée dans un véhicule, et en particulier d'un véhicule autonome.

Le véhicule peut être tout type de véhicule, et en particulier un véhicule terrestre, tel qu'une voiture, autonome ou non.

Le véhicule peut être tout type de véhicule, et en particulier un véhicule volant, tel qu'un avion, un hélicoptère, un drone, etc. autonome ou non.

Alternativement, l'objectif optique peut être un objectif optique d'un appareil d'imagerie médicale.

L'appareil d'imagerie médicale peut être un appareil d'imagerie médicale prévu pour être introduit, au moins une partie, dans le corps d'un sujet.

Suivant des exemples de réalisation non limitatif, l'appareil d'imagerie médicale peut être un endoscope, et encore plus particulièrement d'un endoscope jetable.

### Description des figures et modes de réalisation

D'autres avantages et caractéristiques apparaîtront à l'examen de la description détaillée de modes de réalisation nullement limitatifs, et des dessins annexés sur lesquels :
- la FIGURE 1 est une représentation schématique d'un exemple de réalisation non limitatif d'un élément optique pouvant être utilisé pour fabriquer un objectif optique ;
- la FIGURE 2 est une représentation schématique d'un exemple de réalisation non limitatif d'un objectif optique pouvant être caractérisé par la présente invention ;
- les FIGURES 3a à 3f sont des représentations schématiques d'un exemple non limitatif de réalisation de mesure d'interférométrie optique pouvant être mise en œuvre dans la présente invention ;
- la FIGURE 4 est une représentation schématique d'un exemple de réalisation non limitatif d'un procédé selon l'invention de caractérisation géométrique d'un objectif optique ;
- la FIGURE 5 est une représentation schématique d'un exemple de réalisation non limitatif d'un dispositif selon l'invention de caractérisation géométrique d'un objectif optique ;
- la FIGURE 6 est une représentation schématique d'un exemple de réalisation non limitatif d'une phase d'entrainement pouvant être utilisée dans la présente invention pour entrainer un modèle de caractérisation géométrique ; et
- la FIGURE 7 est une représentation schématique d'un exemple de réalisation non limitatif d'un procédé selon l'invention de fabrication d'un objectif optique.

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieure. Cette sélection comprend au moins une caractéristique de préférence fonctionnelle sans détails structurels, ou avec seulement une partie des détails structurels si c'est cette partie qui est uniquement suffisante pour conférer un avantage technique ou pour différencier l'invention par rapport à l'état de la technique antérieure.

En particulier toutes les variantes et tous les modes de réalisation décrits sont combinables entre eux si rien ne s'oppose à cette combinaison sur le plan technique.

Sur les figures et dans la suite de la description, les éléments communs à plusieurs figures conservent la même référence.

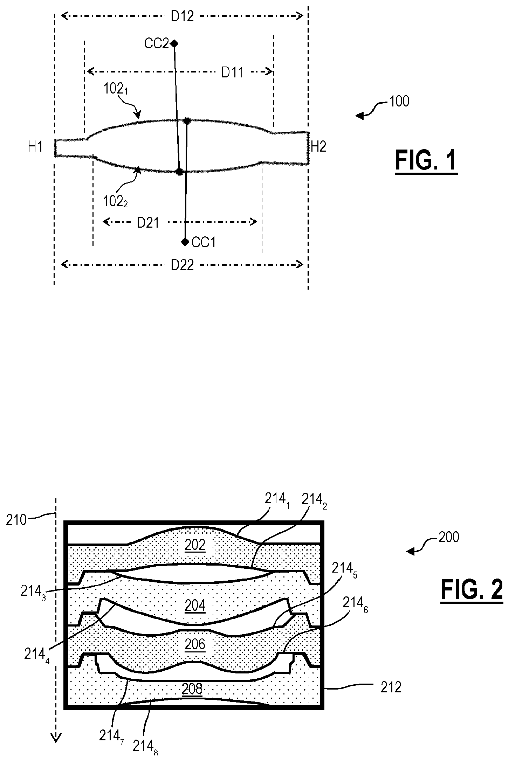

La FIGURE 1 est une représentation schématique d'un exemple de réalisation non limitatif d'un élément optique pouvant être utilisé pour fabriquer un objectif optique.

L'élément optique 100 de la FIGURE 1 peut être utilisé avec au moins un autre élément optique pour fabriquer un objectif optique. Un exemple d'objectif optique, donné à titre d'exemple non limitatif sera décrit en référence à la FIGURE 2.

L'élément optique 100 peut être une lentille, une lame, etc. Dans la suite, et sans perte de généralité, on considère que l'élément optique est une lentille.

La lentille optique 100 peut par exemple être fabriquée par moulage par injection. Un procédé par moulage par injection suit de façon générale la succession d'étapes suivantes :
- injection du polymère et remplissage du moule,
- mise sous pression,
- maintien de la pression,
- refroidissement, et
- démoulage
Les procédés de fabrication de lentille par injection, bien que courants, peuvent fluctuer et générer des erreurs sur les paramètres caractéristiques des lentilles.

La lentille 100 peut être caractérisée par un jeu de paramètres, appelé jeu individuel JI.

Le jeu individuel JI peut comprendre au moins un paramètre relatif au processus de fabrication de la lentille, appelé paramètre de fabrication. Le jeu individuel peut comprendre une combinaison quelconque d'au moins un des paramètres de fabrication suivants :
- une température de moulage, notée TM ;
- une pression de moulage, notée PM ;
- une durée de moulage, notée DM ;
- un polymère utilisé pour le moulage, notée POM ;

Les valeurs de ces paramètres sont généralement déterminées par le fabricant de la lentille. Elles peuvent être soient connues en tant que donnée d'entrée du processus de fabrication, ou mesurées au cours de la fabrication de la lentille.

Par ailleurs, la lentille 100 a une forme géométrique donnée. Elle comporte deux interfaces 102₁ et 102₂, ayant elles aussi, chacune, une forme géométrique donnée. Ainsi, la lentille 100 a une forme qui est caractérisée par au moins un paramètre géométrique relatif à la forme de la lentille. Le jeu individuel JI peut comprendre, alternativement ou en plus, une combinaison quelconque d'au moins un des paramètres géométriques suivants :
- une forme géométrique de chacune des interfaces optiques 102₁ et 102₂ ;
- un centre de courbure, notées CC1 et CC2, de chacune des interfaces optiques 102₁ et 102₂ ;
- une position d'un apex, notées A1 et A2, de chacune des interfaces optiques 102₁ et 102₂ ;
- au moins une épaisseur, noté H1 et H2, de la lentille 100 le long de sa périphérie ;
- un diamètre intérieur, respectivement D11 et D21, et/ou un diamètre extérieur, respectivement D12 et D22, de chacune des interfaces 102₁ et 102₂ ;
- une concentricité ou valeur d'excentricité des interfaces 102₁ et 102₂
- une rugosité de surface de chacune des interfaces optiques 102₁ et 102₂ ;
- etc.

La valeur d'au moins un paramètre géométrique peut être fournie par le fabricant. Alternativement, ou en plus, la valeur d'au moins un paramètre géométrique peut être mesurée par exemple par profilométrie optique ou mécanique. Alternativement, ou en plus, la valeur d'au moins un paramètre géométrique peut être déterminée par simulation, à partir d'une modélisation numérique de la lentille 100. Alternativement, ou en plus, la valeur d'au moins un paramètre géométrique peut être mesurée par exemple par interférométrie optique.

De plus, la lentille 100 à des caractéristiques optiques puisqu'il s'agit d'un élément optique. Elle est donc caractérisée par au moins un paramètre optique. Ainsi, le jeu individuel JI peut comprendre, alternativement ou en plus, au moins un des paramètres optiques suivants :
- un indice de réfraction, notés I1 et I2, de chacune des interfaces optiques 102₁ et 102₂ ;
- un nombre d'Abbé, noté Ab,
- etc.

La valeur d'au moins un paramètre optique peut être fournie par le fabricant. Alternativement, ou en plus, la valeur d'au moins un paramètre optique peut être déterminée par mesure optique par exemple.

Ainsi, suivant un exemple de réalisation non limitatif, un jeu individuel JI d'une lentille peut s'écrire :
JI={TM,PM,DM,PO; CC1,CC2,A1,A2,H1,H2,D11,D12,D21,D22; I1,I2,Ab}

De manière générale, le jeu individuel peut comprendre M1 paramètres avec M1≥1 et préférentiellement M1≥2.

Ce jeu individuel d'une lentille peut être utilisé, avec le jeu individuel d'au moins un autre élément optique d'un objectif optique pour former un jeu, dit jeu d'assemblage, noté JA. Si l'objectif optique comprend N éléments optiques, alors le jeu d'assemblage JA peut comprendre NxM1 paramètres et peut correspondre à une matrice comportant N lignes et M1 colonnes.

Bien entendu, les jeux individuels JI d'au moins deux éléments optiques peuvent comprendre un même nombre de paramètres, ou des nombres différents de paramètres.

La FIGURE 2 est une représentation schématique d'un exemple de réalisation non limitatif d'un objectif optique pouvant être caractérisé par la présente invention.

Un objectif optique a pour fonction de focaliser une image d'une scène dans un plan image, généralement constitué par une caméra CMOS (dite « CMOS Imager System» qui fournit l'acronyme CIS). Un tel objectif optique est généralement constitué d'en empilement d'éléments optiques comprenant une combinaison quelconque d'éléments optiques tels que des lentilles, des rondelles d'espacement et d'opacification, etc.

Lors de la fabrication de l'objectif optique, chaque élément optique dudit objectif est sélectionné individuellement et empilé avec les autres éléments optiques dans un barillet d'assemblage, selon un ordre donné. L'empilement est ensuite solidarisé avec le barillet par des techniques connues, par exemple par collage.

Sur la FIGURE 2, et à titre d'exemple non limitatif seulement, l'objectif optique 200 comprend quatre lentilles 202-208 empilées, dans une direction d'empilement 210, également appelé axe Z, dans un barillet 212. Au moins deux des lentilles 202-208 peuvent être séparées entre elles d'un espace vide, appelé « air gap », ou d'une entretoise ou rondelle, d'espacement, également appelée « spacer ».

Au moins une des lentilles 202-208 peut par exemple être la lentille 100 de la FIGURE 1.

Chacune des lentilles 202-208 comporte deux interfaces, à savoir une interface, dite amont, et une interface, dite avale, dans la direction de l'empilement 210. Ainsi, la lentille 202 a une interface amont 214₁ et une interface avale 214₂, la lentille 204 a une interface amont 214₃ et une interface avale 214₄, la lentille 206 a une interface amont 214₅ et une interface avale 214₆ et la lentille 208 a une interface amont 214₇ et une interface avale 214₈.

Ainsi, pour l'objectif optique 200 de la FIGURE 2, le jeu d'assemblage JA peut comprendre un jeu individuel, noté respectivement JI₁-JI₄, pour chacune des éléments optiques 202-208, de sorte que
JA={JI₁ ;JI₂ ;JI₃ ;JI₄}

Le jeu d'assemblage JA peut être déterminé avant même d'empiler les lentilles de l'objectif optique 200, dès lors que les éléments optiques composants l'objectif optique sont connus. Dans certains modes de réalisation, le jeu d'assemblage peut être déterminé au moment de la conception de chaque élément optique composant l'objectif optique. Il est ainsi possible d'ajuster chaque élément optique au moment de sa conception ou au moment de sa fabrication en vue d'optimiser la qualité de l'objectif optique.

En outre, pour l'objectif optique 200, et de manière générale pour tout objectif optique comprenant un empilement d'éléments optiques, il est possible de déterminer un jeu de données, appelé jeu géométrique, notée JG dans la suite, comprenant des données relatives à au moins un paramètre géométrique d'au moins une, et en particulier de chaque, interface optique 214₁-214₈ dudit empilement.

Un tel jeu géométrique JG peut comprendre des données relatives à l'un quelconque des paramètres géométriques suivants :
- au moins une valeur de position d'au moins une interface 214₁-214₈, ou d'au moins un élément 202-208, optique de l'objectif 200 ;
- au moins une valeur d'épaisseur d'un élément optique 202-208 de l'objectif 200 ;
- au moins une valeur de décentrement d'au moins une interface 214₁-214₈, ou d'au moins un élément 202-208, optique par rapport à l'axe Z, ou relativement à une position de centre d'une autre interface, dans le plan X-Y ; ou
- au moins une valeur d'inclinaison d'au moins une interface 214₁-214₈, ou d'au moins un élément 202-208, optique par rapport à l'axe Z, ou relativement à l'inclinaison une autre interface ;
- au moins une valeur de topographie ou de profil de forme d'au moins une interface optique 214₁-214₈.

De manière générale, le jeu géométrique peut comprendre pour chaque interface optique de l'objectif optique M2 paramètres géométriques avec M2≥1 et préférentiellement M2≥2. Si l'objectif optique comprend N éléments optiques, alors le jeu d'assemblage JG peut comprendre 2NxM2 paramètres et peut correspondre à une matrice comportant 2N lignes et M2 colonnes. Bien entendu, le jeu d'assemblage peut comprendre un même nombre de paramètres géométriques pour au moins deux interfaces optiques, ou des nombres différents de paramètres géométriques pour au moins deux interfaces optiques.

Le jeu géométrique JG peut comprendre directement les valeurs des paramètres géométriques. Ces valeurs peuvent être mesurées, de manière classique, par interférométrie optique ou par mesure(s) confocale(s), préférentiellement depuis un côté ou une face de l'objectif optique 200, de manière à éviter de le tourner.

Alternativement, le jeu géométrique JG peut comprendre des données de mesure brutes, tel que par exemple des données de mesure d'interférométrie optique ou des données de mesure confocales.

La FIGURES 3a est une représentation schématique d'un exemple de réalisation non limitatif d'une mesure d'interférométrie optique pouvant être mise en œuvre dans la présente invention.

La mesure d'interférométrie optique est réalisée par un appareil d'interférométrie optique, ou appareil interférométrique, 300 représenté de manière très schématique, sur la FIGURE 3a. L'appareil 300 comprend une source 302 de lumière et un capteur d'interférométrie 304. La source 302 émet, en direction de l'empilement d'éléments optiques, un faisceau 306 de lumière cohérente, appelé faisceau de mesure, en un point de mesure, ou selon un champ de vue, 308 dans le plan X-Y, perpendiculaire à la direction 210. Le faisceau de mesure 306 parcourt alors l'empilement d'éléments optiques, en particulier dans l'axe Z 210 et traverse chaque interface optique 214ᵢ à tour de rôle. À chaque interface optique 214ᵢ, une partie 310ᵢ du faisceau de mesure 306 est réfléchie, tel que :
- un faisceau 310₁ est réfléchi par l'interface 214₁,
- ...
- un faisceau 310₈ est réfléchi par l'interface 214₈,

Chaque faisceau réfléchi 310ᵢ du faisceau de mesure 306 est alors capté par le capteur 304 se trouvant aussi relié optiquement à la source d'émission 302, et va produire un signal d'interférence lorsque ce faisceau réfléchi 310ᵢ et un faisceau de référence 312, aussi issu de la source 302 de lumière se recombine sur le capteur 304, la différence des trajets parcourus par les deux faisceaux respectifs étant inférieure à la longueur de cohérence de la source d'émission 302. En particulier, pour chaque faisceau réfléchi 310ᵢ le capteur 304 fournit une raie d'interférence, dite raie principale, ou une image d'interférence, selon les modes d'illumination et de détection mises en œuvre, à une distance optique correspondant à la position de l'interface par rapport à la source d'émission 302, ou tout autre référence prédéterminée. Bien entendu, à part le faisceau 310₁ réfléchi par la première interface 214₁ rencontrée par le faisceau de mesure 306, une partie de chacun des autres faisceaux réfléchis 310₂-310₈ peut, elle-même, être réfléchie dans l'autre sens au passage d'une interface précédente, ce qui peut engendrer des faisceaux optiques à réflexion multiples (non représentés) captés par le capteur 304. Ces faisceaux à réflexions multiples engendrent des raies d'interférence, appelées raies secondaires, ou des images secondaires, généralement de plus faible amplitude.

Les mesures d'interférométrie optique peuvent être réalisées avec un faisceau de mesure d'un capteur interférométrique illuminé par une source lumineuse à faible cohérence. Pour cela, l'appareil d'interférométrie optique dispose de moyens de positionnement pour positionner relativement une zone de cohérence du capteur interférométrique 304 au niveau de l'interface à mesurer. L'interface à mesurer peut être une interface enterrée, c'est-à-dire, l'une des interfaces à l'intérieur de l'élément optique. Pour arriver à une telle interface enterrée, le faisceau de mesure doit donc traverser d'autres interfaces de l'objectif optique. Le dispositif interférométrique permet de détecter sélectivement un signal d'interférence pour chaque interface au niveau de laquelle la zone de cohérence est positionnée, c'est-à-dire pour chaque surface se trouvant dans la zone de cohérence puisque la longueur de cohérence de la source lumineuse est ajustée de sorte à être plus courte qu'une distance optique minimale entre deux interfaces optiques adjacentes de l'objectif optique. Ainsi, préférentiellement, pour chaque mesure, une seule interface se trouve dans la zone de cohérence.

Les mesures des interférences peuvent être effectuées selon un champ de vue déterminé par les moyens de mesure de l'appareil. Les mesures peuvent ainsi être réalisées soit en plein champ, soit par balayage du champ de vue.

Des moyens numériques de traitement peuvent être configurés pour produire, à partir du signal d'interférence, une information de forme, ou un paramètre géométrique, de l'interface mesurée selon le champ de vue.

Des exemples d'appareils interférométriques pouvant être mis en œuvre dans le cadre de la présente invention sont, par exemple, décrits dans le document WO2020/245511 A1.

La FIGURE 3b donne une représentation schématique et partielle de données de mesures brutes obtenues pour une mesure d'interférométrie optique, telle que celle décrite en référence à la FIGURE 3a.

Dans cet exemple de mise en œuvre, une illumination selon un point de mesure est utilisée, et la zone de cohérence est déplacée le long de l'axe optique Z 210 grâce à des moyens de déplacement.

Ainsi, comme décrit en référence à la FIGURE 3a, chaque mesure d'interférence fournit des données brutes 320. Les données brutes 320 comprennent des raies principales 322ᵢ, chaque raie principale correspondant à une interface optique. Par exemple, on obtient une raie principale 322₁ pour l'interface 214₁, une raie principale 322₂ pour l'interface 214₂, etc. (l'interface 214₈ n'apparaissant pas sur l'exemple illustré par la FIGURE 3b).

Les données brutes 320 comprennent aussi des raies secondaires correspondant à des réflexions multiples, et associées aux interfaces 214₂-214₈.

La position optique de chaque raie est donnée en abscisse et l'amplitude normalisée de chaque raie est donnée en ordonnées.

Les FIGURES 3c-3f sont des représentations schématiques et partielles d'un autre exemple de données de mesures brutes obtenues pour une mesure d'interférométrie optique, telle que celle décrite en référence à la FIGURE 3a.

Dans l'exemple représenté sur les FIGURES 3c-3f, une illumination selon un mode plein champ est utilisée et la zone de cohérence a été positionnée afin de mesurer une surface de lentille enterrée. La FIGURE 3c présente le signal d'interférence détecté lors d'une mesure de microscopie par holographie numérique (« Digital Holography Microscopy (DHM)», en anglais). Les FIGURES 3d et 3e représentent respectivement les images d'amplitude et de phase (dans cet exemple repliée) calculées à partir du signal d'interférence. La FIGURE 3f est une image de la topographie de la surface d'une lentille enterrée obtenue à partir de l'information de phase.

Tel qu'indiqué plus haut, suivant des modes de réalisation, le jeu géométrique peut comprendre des données de mesure brutes, en partie ou en totalité, à savoir :
- dans une configuration d'illumination selon un point de mesure, par exemple :
   ▪la position, et éventuellement l'amplitude, de chaque raie principale, ou
   ▪la position, et éventuellement l'amplitude, de chaque raie (principale et secondaire) ;
- dans une configuration d'illumination selon un champ de vue, par exemple :
   ▪l'image d'interférence détectée par le capteur d'interférométrie 204,
   ▪l'image d'amplitude associée à l'image d'interférence et/ou l'image de phase associée à l'image d'interférence, ou
   ▪l'image de topographie associée à l'image d'interférence.

Suivant des modes de réalisation, le jeu géométrique peut comprendre, non pas des données de mesure brutes obtenues par une mesure d'interférométrie optique, mais des valeurs de paramètres géométriques relatives aux interfaces optiques de l'objectif, à savoir :
- la position, le long de l'axe Z, de chaque interface 214ᵢ ou de chaque élément optique 302-308. Ces valeurs de distances peuvent être obtenues à partir des données brutes d'une seule mesure interférométrique. Dans ce cas, le jeu géométrique comprend une valeur de distance par interface, respectivement par élément optique ;
- le décentrement par rapport à l'axe Z ou relativement à d'autres interfaces, dans le plan X-Y, de chaque interface 214ᵢ ou de chaque élément optique 202-208. Ces valeurs de décentrement peuvent être déduites à partir d'une image d'interférence associée à une interface optique, par exemple. Dans ce cas, le jeu géométrique comprend deux valeurs (signées) de distance (une selon l'axe X et l'autre selon l'axe Y) pour chaque interface, respectivement élément optique ;
- l'inclinaison par rapport à l'axe Z, ou à l'inclinaison d'autres interfaces optiques de chaque interface optique 214ᵢ ou de chaque élément optique 202-208. Ces valeurs d'inclinaison peuvent être déduites à partir de plusieurs mesures interférométriques réalisées en différents points de mesure, en particulier dans une zone périphérique de l' objectif optique. Dans ce cas, le jeu géométrique comprend deux valeurs d'angle (une par rapport l'axe X et l'autre par rapport à l'axe Y) pour chaque interface, respectivement élément optique.

On comprend en référence à la FIGURE 3a que la mesure d'un jeu géométrique pour un objectif optique peut être chronophage, et nécessiter l'utilisation d'un appareil d'interférométrie optique encombrant. De plus, la mesure d'un jeu géométrique sur un objectif optique nécessite d'arrêter temporairement la fabrication dudit objectif, le temps de faire la mesure, ce qui constitue un ralentissement, ou une perte de temps, dans la production d'un objectif optique.

La présente invention propose de déterminer, pour un objectif optique, dite objectif optique cible, un jeu géométrique par estimation. Pour cela un jeu d'assemblage, tel que décrit en référence aux FIGURES 1 et 2, est donné en entrée d'un modèle de caractérisation géométrique préalablement entrainé qui, en sortie, fournit un jeu géométrique estimé, noté JGE.

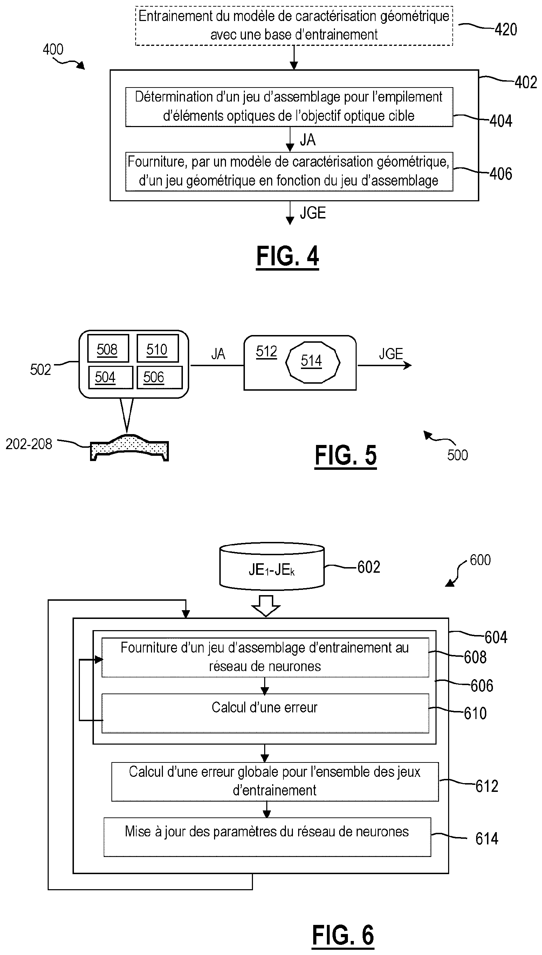

La FIGURE 4 est une représentation schématique d'un exemple de réalisation non limitatif d'un procédé selon l'invention de caractérisation géométrique d'un objectif optique.

Le procédé 400 de la FIGURE 4 peut être utilisé pour la caractérisation géométrique d'un objectif optique comprenant plusieurs lentilles, tel que par exemple l'objectif optique 200 de la FIGURE 2, sans y être limité.

Le procédé 400 comprend une phase 402 de caractérisation d'un objectif optique, dit objectif cible, lors de sa fabrication.

La phase de caractérisation 402 comprend une étape 404 de détermination d'un jeu d'assemblage à partir du jeu individuel, JI, de chaque élément optique composant l'empilement d'éléments optiques de l'objectif optique cible, tel que décrit plus haut. Le jeu individuel JI de chaque élément optique peut comprendre un ou plusieurs paramètres relatifs audit élément optique.

Pour chaque élément optique, au moins un paramètre peut être déterminé tel que décrit plus haut soit à partir d'informations fournies par le fabricant, soit par mesure, soit par simulation.

Cette étape 404 fournit pour l'empilement d'éléments optiques de l'objectif optique un jeu d'assemblage JA comprenant au moins un paramètre caractéristique d'au moins un, et particulier de chaque, élément optique dudit empilement.

La phase de caractérisation 402 comprend une étape 404 lors de laquelle le jeu d'assemblage JA déterminé pour l'objectif optique cible est fourni à un modèle de caractérisation géométrique préalablement entrainé. En réponse, le modèle de caractérisation géométrique fournit un jeu géométrique estimé JGE pour ledit objectif cible.

Le JGE peut comprendre une ou plusieurs valeurs. Préférentiellement, le JGE comprend plusieurs valeurs.

Le jeu géométrique JGE peut comprendre soit des valeurs de paramètres géométriques d'au moins une, et en particulier de chaque, interface optique de l'empilement, tel que par exemple les paramètres géométriques décrits en référence aux FIGURES 3a-3f (alignement, décentrement, etc.).

Le jeu géométrique estimé JGE peut comprendre des valeurs brutes estimées de mesures d'interférométrie optique, ou de mesures confocales, relatives à au moins une, et en particulier à chaque, interface optique de l'empilement, tel que par exemple celles décrites en référence aux FIGURES 3a-3f (signal d'interférence, raies d'interférence, etc.).

De manière optionnelle, le procédé 400 peut comprendre une phase 420 d'entrainement du modèle de caractérisation géométrique avec une base d'entrainement comprenant plusieurs jeux d'entrainements obtenus à partir d'objectifs d'architecture identique à celle de l'objectif cible, soit par mesure soit par simulation. Un exemple non limitatif de phase d'entrainement est décrit plus loin en référence à la FIGURE 6.

Ainsi, le procédé 400 permet une caractérisation géométrique de l'objectif optique cible par estimation avec un modèle de caractérisation géométrique préalablement entrainé, sans réaliser de mesure sur l'empilement d'éléments optiques de l'objectif optique, voire avant même de commencer à fabriquer ledit objectif optique. Ainsi, il est possible d'avoir des indicateurs relatifs à la qualité de l'objectif optique avant de le fabriquer et décider de fabriquer ou non ledit objectif. Par exemple, il est possible d'éviter de fabriquer un objectif optique dont la qualité estimée n'est pas suffisante.

Plus encore, le procédé 400 permet la mise en œuvre de plans d'expérimentations (DOE- « Design of Experiments ») pour faire l'analyse des paramètres des composants, de les classifier suivant les résultats de la caractérisation géométrique obtenue afin, par exemple, de rejeter certains composants très en amont dans la fabrication, de pouvoir apparier des classes entre différents composants optiques ou d'appliquer des corrections inhérentes à cette classe (modification de l'espacement, rotation de la lentille,...).

La FIGURE 5 est une représentation schématique d'un exemple de réalisation non limitatif d'un dispositif selon l'invention de caractérisation géométrique d'un objectif optique.

Le dispositif 500 peut être utilisé pour caractériser au moins un objectif optique, en particulier avant ou pendant sa fabrication, tel que par exemple l'objectif optique 200 de la FIGURE 2.

Le dispositif 500 comprend un module 502 pour déterminer un jeu d'assemblage, à partir des caractéristiques de chaque élément optique composant l'objectif optique cible.

Le module 502 peut comprendre :
- un appareil de profilométrie optique, ou mécanique, 504 ; et/ou
- un appareil d'interférométrie optique 506 en mode point ou en mode plein champ, tel que par exemple l'appareil d'interférométrie optique 300 de la FIGURE 3a.
pour mesurer au moins un paramètre géométrique d'au moins un, en particulier de chaque élément optique prévu pour composer l'objectif optique.

Le module 502 peut comprendre, alternativement ou en plus, une unité informatique 508, tel qu'un processeur ou un calculateur, configuré pour :
- lire dans une base de données des valeurs de paramètres caractéristiques de chaque élément optique prévu pour composer l'objectif optique ; et/ou
- calculer, par simulation et à partir d'une modélisation d'au moins un élément optique, au moins une caractéristique dudit élément optique.

Le module 502 peut comprendre, alternativement ou en plus, une interface utilisateur 510 permettant à un opérateur d'entrer manuellement une valeur d'au moins un paramètre caractéristique d'au moins un élément optique prévu pour composer l'objectif optique.

Le module 502 fournit un jeu d'assemblage JA pour l'empilement des éléments optiques prévus pour composer l'objectif optique.

Le dispositif 500 comprend en outre un module 512 de caractérisation exécutant un modèle 514 de caractérisation géométrique prenant en entrée le jeu d'assemblage JA fourni par le module 502 et fournissant en sortie un jeu géométrique estimé JGE. Le modèle de caractérisation géométrique 514 peut être un programme ou une application informatique et se présenter sous la forme :
- d'un réseau de neurones, en particulier régressif, et encore plus particulièrement un réseau de neurones CNN à apprentissage profond, ou
- un modèle de régression linéaire de polynômes,
- une équation gaussienne, obtenue par une méthode des moindres carrés,
- une méthode d'analyse statistique,
- etc.

Le module de caractérisation géométrique 512 peut être tout module de calcul ou tout module informatique exécutant le modèle de caractérisation 514, tel qu'un serveur, un ordinateur, une tablette, un processeur, un calculateur, une puce électronique, etc.

La FIGURE 6 est une représentation schématique d'un exemple de réalisation non limitatif d'une phase d'entrainement pouvant être utilisé dans la présente invention pour entrainer un modèle de caractérisation géométrique.

La phase d'entrainement 600 de la FIGURE 6 peut être utilisée pour entrainer le modèle de caractérisation géométrique utilisé dans le procédé selon l'invention de caractérisation géométrique d'un objectif optique, et par exemple le procédé 400 de la FIGURE 4, lorsque le modèle d'entrainement est un réseau de neurones.

Le réseau de neurones utilisé peut être un réseau de neurones CNN (pour « Convolutionnal Neural Network »). Il est important de noter que le nombre de couches du réseau de neurones est fonction du nombre de données dans le jeu d'assemblage fourni en entrée dudit réseau de neurones, et du nombre de données dans le jeu géométrique souhaité en sortie.

La phase d'entrainement 600 est réalisée avec une base d'entrainement 602 comprenant une multitude de jeux de données d'entrainement, notés JE₁-JEₖ, Chaque jeu d'entrainement JEᵢ comprend, pour un objectif optique d'entrainement :
- au moins un jeu d'assemblage d'entrainement, JAAᵢ ; et
- un jeu géométrique d'entrainement, JGAᵢ.

L'objectif optique d'entrainement présente une architecture identique à celle de l'objectif optique cible qu'on souhaite caractériser par le modèle de caractérisation géométrique

Chaque jeu d'assemblage d'entrainement JAAᵢ peut être obtenu par exemple tel que décrit plus haut en référence aux FIGURES 1 et 2, c'est-à-dire en déterminant un jeu individuel pour chaque élément optique composant l'objectif optique d'entrainement puis le jeu d'assemblage d'entrainement à partir desdits jeux individuels.

Chaque jeu géométrique d'entrainement JGAᵢ peut être obtenu par exemple par mesure sur l'objectif optique d'entrainement, par exemple par interférométrie optique tel que décrit plus haut en référence aux FIGURES 3a-3f, ou par simulation à partir d'une modélisation numérique de l'objectif optique d'entrainement.

La phase d'entrainement 600 comprend une étape d'entrainement 604.

L'étape d'entrainement 604 comprend une étape de test 606.

L'étape de test 606 comprend une étape 608 lors de laquelle un jeu d'assemblage d'entrainement, par exemple JAA₁, d'un jeu d'entrainement, par exemple JE₁, est donné en entrée du réseau de neurones. Le réseau de neurones donne en sortie un jeu géométrique d'entrainement estimé, noté JGA₁^{e}.

Lors d'une étape 610 de l'étape de test 606, une erreur, E₁, peut être calculée entre le jeu JGAᵢ^{e} et le jeu JGA₁. L'erreur calculée E₁ peut par exemple être une distance euclidienne ou une distance cosinus entre le jeu JGA₁^{e} et le jeu JGA₁.

L'étape de test 606 peut être réitérée pour chaque jeu d'entrainement JE₁-JEₖ, de sorte qu'il est obtenu k valeurs d'erreur E₁-Eₖ associées respectivement à chaque jeu d'entrainement JE₁-JEₖ.

L'étape d'entrainement 604 peut ensuite comprendre une étape 612 de calcul d'une erreur globale, EG, pour l'ensemble des jeux d'entrainement, JE₁-JEₖ, par exemple en additionnant les k erreurs JE₁-JEₖ obtenues.

L'étape d'entrainement 604 peut ensuite comprendre une étape 614 de rétroaction, lors de laquelle les coefficients, ou poids, du réseau de neurones CNN peuvent être mis à jour, par exemple par un algorithme de rétropropagation du gradient de l'erreur.

L'étape d'entrainement 604 peut être répétée plusieurs fois jusqu'à ce que l'erreur global EG ne varie plus pendant plusieurs, par exemple 5, itérations successives. Lorsque c'est le cas, le réseau de neurones CNN peut être considéré suffisamment entrainé et la phase d'entrainement peut être terminée.

Alternativement, ou en plus de ce qui vient d'être décrit, il est possible d'utiliser une première partie de la base d'entrainement 602, par exemple JE₁-JEⱼ, pour l'entrainement du réseau de neurones et une deuxième partie de la base d'entrainement 602, par exemple JEⱼ₊₁-JEₖ, pour valider l'entrainement du réseau de neurones. Si les sorties du réseau de neurones obtenues sont assez proches des valeurs attendues, l'apprentissage peut être considéré comme acceptable. Sinon, plus de jeux d'entrainements peuvent présentés, ou bien la topologie du réseau est modifiée (nombre de couches, nombre de neurones par couches...) jusqu'à obtention d'un apprentissage satisfaisant.

Bien entendu, le modèle de caractérisation géométrique n'est pas limité à un réseau de neurones.

Suivant une alternative, le modèle de caractérisation géométrique peut comprendre, ou peut être, une méthode de recherche de corrélations, par exemple par méthode de régression, entre le jeu d'assemblage d'entrainement JAAᵢ et le jeu de géométrique d'entrainement JGAᵢ de chaque jeu d'entrainement JEᵢ.

Suivant un exemple de réalisation, la recherche des corrélations peut se faire via une méthode des moindres carrés. Elle peut consister à la mise en place d'une relation polynomiale supposée entre les JAAᵢ et IGAᵢ, et cela pour chaque JEᵢ. Ensuite, la méthode des moindres carrés permet de trouver le meilleur jeu de coefficients des polynômes qui minimise l'erreur entre les sorties calculées par les polynômes obtenus et les JGAᵢ.

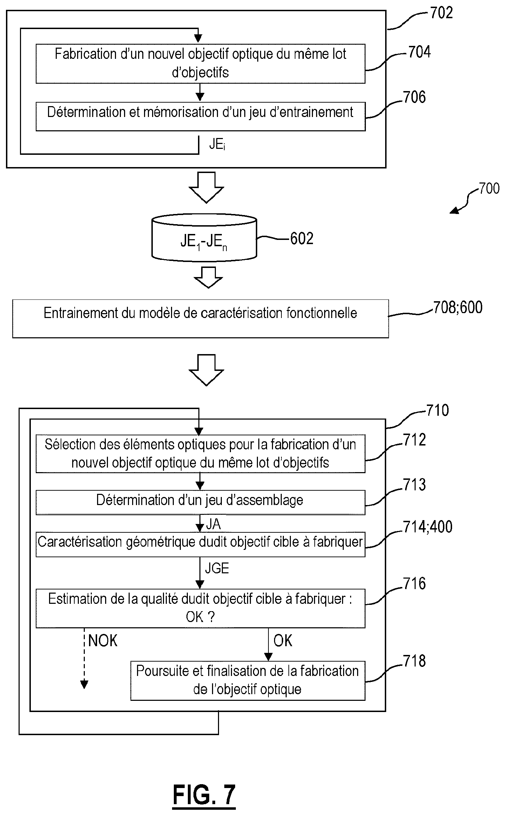

La FIGURE 7 est une représentation schématique d'un exemple de réalisation non limitatif d'un procédé selon l'invention de fabrication d'objectifs optiques.

Le procédé 700 peut comprendre une première phase 702 de fabrication lors de laquelle une première partie d'un lot d'objectifs est fabriqué. Cette première partie comprend une multitude d'objectifs optiques. Lors de cette phase 702 un objectif optique est fabriqué lors d'une étape 704, puis un jeu d'entrainement JE est déterminé et mémorisé lors d'une étape 706, en vue de constituer une base d'entrainement, tel que par exemple la base d'entrainement 602.

Puis, lors d'une étape 708, le modèle de caractérisation géométrique est entrainé avec la base d'entrainement, par exemple en mettant œuvre la phase d'entrainement 600 de la FIGURE 6.

Le procédé 700 peut ensuite comprendre une deuxième phase 710 de fabrication lors de laquelle les objectifs restant du lot sont fabriqués.

Cette phase 710 comprend, pour chaque objectif optique, une étape 712 de sélection des éléments optiques qui vont constituer l'objectif optique.

Lors d'une étape 713, un jeu d'assemblage est déterminé pour l'empilement d'éléments optiques sélectionnés.

Lors d'une étape 714, préférentiellement réalisée avant empilement des éléments optiques, l'objectif optique à fabriquer est caractérisé, en utilisant le modèle de caractérisation géométrique obtenu à l'étape 708, par le procédé selon l'invention de caractérisation fonctionnelle, et en particulier par le procédé 400 de la FIGURE 4, pour obtenir un jeu géométrique estimé pour l'objectif optique cible à fabriquer.

Ensuite, lors d'une étape 716 au moins une, et en particulier chaque, valeur du jeu géométrique estimé obtenu peut être comparée à au moins une fourchette de valeurs géométriques pour déterminer si la qualité attendue de l'objectif optique est satisfaisante.

Si le jeu géométrique estimé témoigne d'une qualité satisfaisante l'objectif optique, la fabrication de l'objectif optique peut être commencée ou poursuivie lors d'une étape 718.

Si le jeu géométrique estimé témoigne d'une qualité insuffisante, alors la fabrication de l'objectif optique peut être annulée. Alternativement, si le jeu géométrique estimé témoigne d'une qualité insuffisante, alors la composition de l'objectif optique peut être retouchée. Par exemple, au moins un élément optique de l'objectif optique peut être remplacé.

Bien entendu l'invention n'est pas limitée aux exemples qui viennent d'être décrits.

## Revendications

1. Procédé (400) mis en oeuvre par ordinateur de caractérisation géométrique d'un objectif optique cible (200) à fabriquer par empilement de plusieurs éléments optiques (202-208), ledit procédé (400) comprenant une phase de caractérisation (402) comprenant les étapes suivantes :
- détermination (404), d'un jeu, dit jeu d'assemblage (JA), comprenant, pour chacun d'au moins deux éléments optiques (202-208), un jeu, dit jeu individuel, comprenant au moins un paramètre caractéristique dudit élément optique (202-208) ; **caractérisé par** :
- fourniture (406), en fonction dudit jeu d'assemblage (JA), d'un jeu de données (JGE), dit jeu géométrique estimé, comprenant des données relatives à au moins un paramètre géométrique pour chacune d'au moins deux interfaces optiques (214₁-214₈) dudit empilement, par un modèle de caractérisation géométrique (514), préalablement entrainé avec une base (602), dite base d'entrainement, de jeux d'entrainements (JE₁-JEₖ) constituée à partir d'objectifs optiques d'architecture identique à celle dudit objectif cible.

2. Procédé (400) selon la revendication précédente, **caractérisé en ce qu'**au moins un jeu individuel d'un élément optique (202-208) comprend une combinaison quelconque d'au moins un des paramètres suivants :
- au moins un paramètre optique dudit élément optique (202-208) ;
- au moins un paramètre géométrique dudit élément optique (202-208) ;
- au moins un paramètre de fabrication dudit élément optique (202-208).

3. Procédé (400) selon l'une quelconque des revendications précédentes, **caractérisé en ce qu'**au moins un paramètre d'un élément optique (202-208) est :
- fourni par un fournisseur dudit élément optique (202-208),
- mesuré par un dispositif de mesure, ou
- calculé à partir d'une modélisation numérique dudit élément optique (202-208).

4. Procédé (400) selon l'une quelconque des revendications précédentes, **caractérisé en ce que** le jeu géométrique estimé (JGE) comprend la valeur estimée d'au moins un paramètre géométrique d'une interface optique (214₁-214₈) de l'objectif cible (200).

5. Procédé (400) selon l'une quelconque des revendications 1 à 3, **caractérisé en ce que** le jeu géométrique estimé (JGE) comprend des données estimées d'une partie, ou de la totalité, de valeurs brutes (320) de mesure(s) optique(s) obtenues à partir de l'empilement d'éléments optiques (202-208) dudit objectif optique cible (200)

6. Procédé (400) selon l'une quelconque des revendications précédentes, **caractérisé en ce qu'**au moins un jeu d'entrainement (JE₁-JEₖ) comprend :
- au moins un jeu d'assemblage, dit d'entrainement, obtenu à partir d'un objectif optique, dite d'entrainement, d'architecture identique à l'architecture de l'objectif cible (200), et
- au moins un jeu géométrique, dit d'entrainement, obtenu à partir dudit objectif optique d'entrainement.

7. Procédé (400) selon l'une quelconque des revendications précédentes, **caractérisé en ce que** la base d'entrainement (602) comprend au moins un jeu d'entrainement (JE₁-JEₖ) obtenu à partir d'un objectif d'entrainement faisant partie d'un même lot d'objectifs que l'objectif cible, lors de la fabrication dudit lot d'objectifs.

8. Procédé (400) selon l'une quelconque des revendications précédentes, **caractérisé en ce que** le modèle de caractérisation géométrique (514) comprend :
- un réseau de neurones, en particulier régressif, et encore plus particulièrement un réseau de neurones CNN à apprentissage profond,
- un modèle de régression linéaire de polynômes,
- une équation gaussienne, obtenue par une méthode des moindres carrés, ou
- une méthode d'analyse statistique.

9. Procédé (400) selon l'une quelconque des revendications précédentes, **caractérisé en ce qu'**il comprend une phase (420;600) d'entrainement du modèle de caractérisation géométrique avec la base d'entrainement (602).

10. Dispositif (500) de caractérisation géométrique d'un objectif optique cible (200) à fabriquer par empilement de plusieurs éléments optiques (202-208), ledit dispositif (500) comprenant :
- au moins un moyen (502) de détermination, d'un jeu (JA), dit jeu d'assemblage, comprenant, pour chacun d'au moins deux éléments optiques (202-208), un jeu, dit jeu individuel, comprenant au moins un paramètre caractéristique dudit élément optique (202-208) ; **caractérisé par** :
- un module informatique (512) configuré pour exécuter un modèle de caractérisation géométrique (514) préalablement entrainé avec une base (602), dite base d'entrainement, de jeux d'entrainements (JE₁-JEₖ) constituée à partir d'objectifs optiques d'architecture identique à celle dudit objectif cible (200), pour fournir, en fonction dudit jeu d'assemblage, un jeu de données (JGE), dit jeu géométrique estimé, comprenant des données relatives à au moins un paramètre géométrique pour chacune d'au moins deux interfaces optiques (214₁-214₈) dudit empilement.

11. Procédé (700) de fabrication d'un lot d'objectifs optiques comportant une deuxième phase de fabrication (710) comprenant au moins une itération d'une étape de fabrication d'un objectif optique dudit lot comprenant les opérations suivantes :
- détermination (713) d'un jeu d'assemblage pour ledit objectif optique, à partir de jeux individuels pour chacun des éléments optiques dudit objectif optique, et
- caractérisation (714;400) dudit objectif par le procédé (400) de caractérisation selon l'une quelconque des revendications 1 à 9.

12. Procédé (700) selon la revendication précédente, **caractérisé en ce qu'**il comprend en outre une première phase de fabrication (702), préalable à la deuxième phase de fabrication (710), comprenant plusieurs itérations d'une étape de fabrication d'un objectif optique du lot d'objectifs comprenant les opérations suivantes :
- détermination d'un jeu d'assemblage pour ledit objectif optique, à partir de jeux individuels des éléments optiques dudit objectif optique, et
- empilement des éléments optiques formant ledit objectif optique,
- mesure d'un jeu géométrique sur ledit objectif optique,
- mémorisation (706), dans une base d'entrainement (602), d'un jeu d'entrainement (JEᵢ) formé par :
▪ledit jeu d'assemblage, et
▪ledit jeu géométrique mesuré.

## Patentansprüche

1. Computerimplementiertes Verfahren (400) für eine geometrische Charakterisierung eines optischen Zielobjektivs (200), das durch Stapeln mehrerer optischer Elemente (202-208) herzustellen ist, wobei das Verfahren (400) eine Charakterisierungsphase (402) umfasst, die die folgenden Schritte umfasst:
- Bestimmen (404) eines Satzes, Montagesatz (JA) genannt, umfassend, für jedes von mindestens zwei optischen Elementen (202-208), einen Satz, Einzelsatz genannt, umfassend mindestens einen charakteristischen Parameter des optischen Elements (202-208); **gekennzeichnet durch**:
- Bereitstellen (406), in Abhängigkeit von dem Montagesatz (JA), eines Datensatzes (JGE), geschätzter geometrischer Satz genannt, umfassend Daten bezüglich mindestens eines geometrischen Parameters für jede von mindestens zwei optischen Grenzflächen (214₁-214₈) des Stapels, durch ein geometrisches Charakterisierungsmodell (514), das zuvor mit einer Basis (602), Trainingsbasis genannt, von Trainingssätzen (JE₁-JEₖ) trainiert wurde, die aus optischen Objektiven mit einer Architektur gebildet ist, die mit der des Zielobjektivs identisch ist.

2. Verfahren (400) nach dem vorstehenden Anspruch, **dadurch gekennzeichnet, dass** mindestens ein Einzelsatz eines optischen Elements (202-208) eine beliebige Kombination aus mindestens einem der folgenden Parameter umfasst:
- mindestens einem optischen Parameter des optischen Elements (202-208);
- mindestens einem geometrischen Parameter des optischen Elements (202-208);
- mindestens einem Herstellungsparameter des optischen Elements (202-208).

3. Verfahren (400) nach einem der vorstehenden Ansprüche, **dadurch gekennzeichnet, dass** mindestens ein Parameter eines optischen Elements (202-208) ist:
- bereitgestellt durch einen Lieferanten des optischen Elements (202-208),
- gemessen durch eine Messvorrichtung oder
- berechnet aus einer numerischen Modellierung des optischen Elements (202-208).

4. Verfahren (400) nach einem der vorstehenden Ansprüche, **dadurch gekennzeichnet, dass** der geschätzte geometrische Satz (JGE) den geschätzten Wert mindestens eines geometrischen Parameters einer optischen Grenzfläche (214₁- 214₈) des Zielobjektivs (200) umfasst.

5. Verfahren (400) nach einem der Ansprüche 1 bis 3, **dadurch gekennzeichnet, dass** der geschätzte geometrische Satz (JGE) geschätzte Daten eines Teils oder der Gesamtheit von Rohwerten (320) optischer Messung(en) umfasst, die aus dem Stapel optischer Elemente (202-208) des optischen Zielobjektivs (200) erhalten werden.

6. Verfahren (400) nach einem der vorstehenden Ansprüche, **dadurch gekennzeichnet, dass** mindestens ein Trainingssatz (JE₁-JEₖ) umfasst:
- mindestens einen Montagesatz, Trainingsmontagesatz genannt, erhalten aus einem optischen Objektiv, Trainingsobjektiv genannt, mit einer Architektur, die identisch mit der Architektur des Zielobjektivs (200) ist, und
- mindestens einen geometrischen Satz, geometrischer Trainingssatz genannt, erhalten aus dem optischen Trainingsobjektiv.

7. Verfahren (400) nach einem der vorstehenden Ansprüche, **dadurch gekennzeichnet, dass** die Trainingsbasis (602) mindestens einen Trainingssatz (JE₁-JEₖ), der aus einem Trainingsobjektiv, das zu derselben Charge von Objektiven wie das Zielobjektiv gehört, während der Herstellung der Charge von Objektiven erhalten wird, umfasst.

8. Verfahren (400) nach einem der vorstehenden Ansprüche, **dadurch gekennzeichnet, dass** das geometrische Charakterisierungsmodell (514) umfasst:
- ein neuronales Netz, insbesondere ein regressives, und ganz besonders ein neuronales CNN-Netz mit Deep Learning,
- ein lineares Regressionsmodell von Polynomen,
- eine Gaußsche Gleichung, erhalten durch eine Methode der kleinsten Quadrate, oder
- ein statistisches Analyseverfahren.

9. Verfahren (400) nach einem der vorstehenden Ansprüche, **dadurch gekennzeichnet, dass** es eine Phase (420; 600) zum Trainieren des geometrischen Charakterisierungsmodells mit der Trainingsbasis (602) umfasst.

10. Vorrichtung (500) für die geometrische Charakterisierung eines optischen Zielobjektivs (200), das durch Stapeln mehrerer optischer Elemente (202-208) herzustellen ist, wobei die Vorrichtung (500) umfasst:
- mindestens ein Mittel (502) zum Bestimmen eines Satzes (JA), Montagesatz genannt, umfassend für jedes von mindestens zwei optischen Elementen (202-208) einen Satz, Einzelsatz genannt, umfassend mindestens einen charakteristischen Parameter des optischen Elements (202-208); **gekennzeichnet durch**:
- ein Computermodul (512), das zum Ausführen eines geometrischen Charakterisierungsmodells (514) konfiguriert ist, das zuvor mit einer Basis (602), Trainingsbasis genannt, von Trainingssätzen (JE₁-JEₖ) trainiert wurde, die aus optischen Objektiven mit einer Architektur gebildet ist, die mit der des Zielobjektivs (200) identisch ist, zum Bereitstellen, in Abhängigkeit von dem Montagesatz, eines Datensatzes (JGE), geschätzter geometrischer Satz genannt, umfassend Daten bezüglich mindestens eines geometrischen Parameters für jede von mindestens zwei optischen Grenzflächen (214₁-214₈) des Stapels.

11. Verfahren (700) zum Herstellen einer Charge von optischen Objektiven, das eine zweite Herstellungsphase (710) umfasst, die mindestens eine Iteration eines Schritts der Herstellung eines optischen Objektivs der Charge umfasst, umfassend die folgenden Vorgänge:
- Bestimmen (713) eines Montagesatzes für das optische Objektiv aus Einzelsätzen für jedes der optischen Elemente des optischen Objektivs und
- Charakterisieren (714;400) des Objektivs durch das Verfahren (400) zum Charakterisieren nach einem der Ansprüche 1 bis 9.

12. Verfahren (700) nach dem vorstehenden Anspruch, **dadurch gekennzeichnet, dass** es ferner eine erste Herstellungsphase (702) vor der zweiten Herstellungsphase (710) umfasst, die mehrere Iterationen eines Schritts der Herstellung eines optischen Objektivs der Charge von Objektiven umfasst, umfassen die folgenden Vorgänge:
- Bestimmen eines Montagesatzes für das optische Objektiv aus Einzelsätzen der optischen Elemente des optischen Objektivs, und
- Stapeln der optischen Elemente, die das optische Objektiv ausbilden,
- Messen eines geometrischen Satzes an dem optischen Objektiv,
- Speichern (706), in einer Trainingsdatenbank (602), eines Trainingssatzes (JEᵢ), gebildet durch:
▪ den Montagesatz und
▪ den gemessenen geometrischen Satz.

## Claims

1. A computer implemented method (400) for geometric characterization of a target optical objective (200) to be manufactured by stacking several optical elements (202-208), said method (400) comprising a characterization phase (402) comprising the following steps:
- determining (404) a set, called assembly set (JA), comprising, for each of at least two optical elements (202-208), a set, called individual set, comprising at least one parameter characteristic of said optical element (202-208);
**characterized by**:
- providing (406), as a function of said assembly set (JA), a data set (JGE), called estimated geometric set, comprising data relating to at least one geometric parameter for each of at least two optical interfaces (214₁-214₈) of said stack, by a geometric characterization model (514) trained beforehand with a database (602), called training database, of training sets (JE₁-JEₖ) constituted with optical objectives with architecture identical to that of said target objective.

2. The method (400) according to the preceding claim, **characterized in that** at least one individual set of an optical element (202-208) comprises any combination of at least one of the following parameters:
- at least one optical parameter of said optical element (202-208);
- at least one geometric parameter of said optical element (202-208);
- at least one manufacturing parameter of said optical element (202-208).

3. The method (400) according to any one of the preceding claims, **characterized in that** at least one parameter of an optical element (202-208) is:
- provided by a supplier of said optical element (202-208),
- measured by a measurement device, or
- calculated based on a digital modelling of said optical element (202-208).

4. The method (400) according to any one of the preceding claims, **characterized in that** the estimated geometric set (JGE) comprises the estimated value of at least one geometric parameter of an optical interface (214₁-214₈) of the target objective (200).

5. The method (400) according to any one of claims 1 to 3, **characterized in that** the estimated geometric set (JGE) comprises estimated data of a part, or all, of the raw optical measurement values (320) obtained from the stack of optical elements (202-208) of said target optical objective (200).

6. The method (400) according to any one of the preceding claims, **characterized in that** at least one training set (JE₁-JEₖ) comprises:
- at least one assembly set, called training assembly set, obtained from an optical objective, called training optical objective, with architecture identical to the architecture of the target objective (200), and
- at least one geometric set, called training geometric set, obtained from said training optical objective.

7. The method (400) according to any one of the preceding claims, **characterized in that** the training database (602) comprises at least one training set (JE₁-JEₖ) obtained from a training objective forming part of one and the same batch of objectives as the target objective, during the manufacture of said batch of objectives.

8. The method (400) according to any one of the preceding claims, **characterized in that** the geometric characterization model (514) comprises:
- a neural network, in particular a regression neural network, and even more particularly a deep learning CNN neural network,
- a polynomial linear regression model,
- a Gaussian equation, obtained by a least squares method, or
- a statistical analysis method.

9. The method (400) according to any one of the preceding claims, **characterized in that** it comprises a phase (420;600) of training the geometric characterization model with the training database (602).

10. A device (500) for geometric characterization of a target optical objective (200) to be manufactured by stacking several optical elements (202-208), said device (500) comprising:
- at least one means (502) for determining a set (JA), called assembly set, comprising, for each of at least two optical elements (202-208), a set, called individual set, comprising at least one parameter characteristic of said optical element (202-208); and **characterized by**:
- a processing module configured for executing a geometric characterization model (514) trained beforehand with a database (602), called training database, of training sets (JE₁-JEₖ) constituted with optical objectives with architecture identical to that of said target objective (200) to provide, as a function of said assembly set, a data set (JGE), called estimated geometric set, comprising data relating to at least one geometric parameter for each of at least two optical interfaces (214₁-214₈) of said stack.

11. A method (700) for the manufacture of a batch of optical objectives including a second manufacture phase (710) comprising at least one iteration of a step of manufacture of an optical objective of said batch comprising the following operations:
- determining (713) an assembly set for said optical objective, based on individual sets for each of the optical elements of said optical objective, and
- characterizing (714;400) said objective by the characterization method (400) according to any one of claims 1 to 9.

12. The method (700) according to the preceding claim, **characterized in that** it also comprises a first manufacture phase (702), prior to the second manufacture phase (710), comprising several iterations of a step of manufacture of an optical objective from the batch of objectives comprising the following operations:
- determining an assembly set for said optical objective, based on individual sets of the optical elements of said optical objective, and
- stacking the optical elements forming said optical objective,
- measuring a geometric set on said optical objective,
- storing (706), in a training database (602), a training set (JEᵢ) formed by:
▪ said assembly set, and
▪ said measured geometric set.
